Europäisches Patentamt

European Patent Office

Office européen des brevets

(19)

(11) Veröffentlichungsnummer: **0 002 063**
**B1**

(12) **EUROPÄISCHE PATENTSCHRIFT**

(21) Anmeldenummer: **78101408.9**

(22) Anmeldetag: **18.11.78**

(51) Int. Cl.³: **H 05 K 13/00,**
**G 02 B 23/10**

(54) Vorrichtung zur Erzeugung einer Auflichtanzeige auf einer zu bestückenden Leiterplatte.

(30) Priorität: **22.11.77 DE 2752145**

(43) Veröffentlichungstag der Anmeldung:
**30.05.79 Patentblatt 79/11**

(45) Bekanntmachung des Hinweises auf die Patenterteilung:
**11.02.81 Patentblatt 81/6**

(84) Benannte Vertragsstaaten:
**BE CH FR GB NL SE**

(56) Entgegenhaltungen:
**DE - A - 1 588 412**
**DE - A - 2 046 475**
**DE - A - 2 547 750**
**DE - A - 2 716 548**

(73) Patentinhaber: **Firma Peter Jordan**
**Mainstrasse 5-7**
**D-6050 Offenbach (Main) (DE)**

(72) Erfinder: **Kroschewski, Jonadab**
**Julius-Leber-Strasse 7**
**D-6050 Offenbach (DE)**

(74) Vertreter: **Oppermann, Ewald**
**Am Wiesengrund 35**
**D-6050 Offenbach (Main) (DE)**

Courier Press, Leamington Spa, England.

Vorrichtung zur Erzeugung einer Auflichtanzeige auf einer zu bestückenden Leiterplatte

Die Erfindung bezieht sich auf eine Vorrichtung zur Erzeugung einer durch ein festgelegtes Bestückungsprogramm gesteuerten Auflichtanzeige auf einer mit elektronischen Bauelementen zu bestückenden Leiterplatte, auf welcher ein Lichtpunkt den Ort und die Sequenz der vorzunehmenden Bestückungsschritte anzeigt, mit einer zwischen einer Lichtquelle und einem Projektionsobjektiv angeordneten Blende.

Eine Vorrichtung zur Erzeugung einer Auflichtanzeige dient im Rahmen einer halbautomatischen Einrichtung zur Bestückung elektronischer Leiterplatten von Hand. Hierbei wird die mit Anschlußbohrungen für die Leiteranschlüsse der elektronischem Bauelemente versehene noch unbestückte Leiterplatte in eine Haltevorrichtung eingespannt, die auf der Tischplatte eines Arbeitstisches montiert ist. In der Nähe der vorderen Kante des Arbeitstisches ist in der Tischplatte eine Öffnung angebracht, durch welche die jeweils zu bestückenden Bauelemente entnommen werden können. Diese Bauelemente befinden sich in einer Ebene unterhalb der Tischplatte in Sortimentkästen, welche mit Hilfe einer geeigneten Mechanik in Ablaufrichtung unter die Tischplattenöffnung gesteuert werden. Für die Zeitdauer des Sortimentkastenvorschubs ist die Tischöffnung durch eine Klappe verschlossen, so daß keine Entnahme von Bauelementen erfolgen kann. Während der Zeitdauer, in welcher die Klappe in der Tischöffnung den Sortimentkasten mit den im Bestückungsablauf vorgesehenen Bauelementen freigibt, bezeichnet der Lichtpunkt diejenige Stelle auf der Leiterplatte, an der dieses Bauelement eingefügt werden muß. Die Vorrichtung zur Erzeugung des Lichtpunktes ist auf einem mit dem Arbeitstisch fest verbundenen Ständer senkrecht über der Ebene der Leiterplatte angeordnet. Die Auslenkung der schwenkbar angebrachten Vorrichtung kann für jeden Bestückungsablauf so vorprogrammiert werden, daß der erzeugte Lichtpunkt genau an der im Bestückungsablauf gewünschten Stelle der Leiterplatte als Auflicht erscheint.

Bei bekannten Vorrichtungen zur Erzeugung einer Auflichtanzeige erfolgt die Lichtpunktanzeige durchweg dynamisch, d.h. der Lichtpunkt wandert zwischen den verschiedenen Bohrungen hin und her. Dieses Verfahren strengt das visuelle Wahrnehmungsvermögen der am Bestückungstisch arbeitenden Bedienungsperson erheblich an und führt zum raschen Nachlassen der Konzentration der Bedienungsperson durch Ermüdung. Darüber hinaus bereiten die bekannten Vorrichtungen mit Lichtpunktanzeige bei bestimmter Zuordnung von Leiteranschlüssen zu bestimmten Leiterplattenbohrungen, z.B. bei gepolten Anschlüssen, erhebliche Zuordnungsschwierigkeiten, welche Falschbestückungen verursachen können und auch nicht absolut fehlerfrei lösbar sind, wenn z. B. der Lichtpunkt zwischen den Leiterplattenbohrungen hin und her wandert und dabei an den verschiedenen Bohrungen unterschiedlich lange verweilt. Die Beobachtung der unterschiedlichen Verweildauer des Lichtpunktes an den verschiedenen Leiterplattenbohrungen trägt zur Ermüdung der Bedienungsperson bei. Hinzu tritt noch, daß das Leiterplattenmaterial häufig opak ist, während die Leiterbahnen selbst reflektierend sind. Hierdurch kommt es bei dynamischer Lichtpunktanzeige häufig zu Streulichterscheinungen, welche die Beobachtung zusätzlich erschweren.

Bein einer bekannten Vorrichtung der eingangs bezeichneten Gattung (DE—A—2 547 750), bei welcher anstelle der Blende ein Projektions-Display oder eine Projektionsmatrix zwischen einer Lichtquelle und einem Projektionsobjektiv angeordnet ist, werden im Projektions-Display bzw. in der Projektionsmatrix vorgesehene lichtdurchlässige Stellen numerisch gesteuert zeilen- und spaltenweise als Lichtmarken auf eine herzustellende Baugruppe projiziert. Diese bekannte Vorrichtung zur Lichtmarkenprojektion ist durch die Verwendung spezieller Displays bzw. Matrizes aufwendig und führt nicht zu zufriedenstellend deutlichen und verwechslungsfreien Auflichtanzeigen, so daß die optische Verfolgung der Bestückungsschritte durch die Bedienungsperson erschwert ist.

Der Erfindung liegt die Aufgabe zugrunde, eine Vorrichtung bereitzustellen, welche die Erzeugung einer verwechslungsfreien Auflichtanzeige ermöglicht, die Augen der Bedienungsperson schont, damit einer raschen Ermüdung derselben vorbeugt und einen schnellen fehlerfreien Bestückungsarbeitsablauf ermöglicht.

Die gestellte Aufgabe wird bei einer Vorrichtung der eingangs bezeichneten Gattung dadurch gelöst, daß die Blende in einem kardanisch aufgehängten und durch zwei im rechten Winkel zueinander und parallel zum Bestückungstisch bzw. zur darauf befindlichen Leiterplatte ausgerichtete unabhängig voneinander antreibbare Vorschubspindeln bewegbaren Projektionsgehäuse angeordnet ist und in ihrer Mitte eine kreisrunde Öffnung und vier um die kreisrunde Öffnung nach Art eines Kreuzes angeordnete jeweils um 90° gegeneinander versetzte Schlitzöffnungen besitzt, wobei jeder Schlitzöffnung ein unabhängig bewegbares Abdeckelement zugeordnet ist.

Durch das besondere Lichtsymbol und die vorgesehene Möglichkeit, einzelne oder alle Lichtbalken bei der Projektion abzudecken, ermöglicht die erfindungsgemäße Vorrichtung die Erzeugung im geometrischen Erscheinungsbild unterschiedlicher Lichtsymbole auf der Leiterplatte, wodurch die Zuordnung von Leiteranschlüssen der elektronischen Bauelemente zu den dafür bestimmten Leiterplattenbohrungen außerordentlich verdeutlicht und vereinfacht wird. Die erzeugten Lichtsymbole dienen zum unverwechselbaren Bezeichnen derjenigen Bohrungen in der Leiterplatte, welche die Anschlüsse des zu bestückenden Bauelements aufnehmen sollen. Hierbei kommt den variablen Lichtbalkensymbolen ein unmißverständlicher Zeigercharakter zu. Die erfindungsgemäße Vorrichtung macht die Aufbringung eines besonderen Bestückungsdruckes auf Leiterplatten überflüssig.

Die erfindungsgemäße Vorrichtung ermöglicht es, daß die Lichtbalken unter Beibehaltung ihrer gegenseitigen Winkelzuordnung um den Lichtpunkt gedreht projiziert werden. Damit wird eine Anpassung des Lichtsymbols an alle auf Leiterplatten vorkommenden Bestückungserfordernisse ermöglicht. Die Drehung der Lichtbalken um den Lichtpunkt herum kann kontinuierlich erfolgen. Für bestimmte Anwendungszwecke ist es jedoch vorteilhaft, wenn die Lichtbalken gegenüber der Ausgangslage um den festen Winkelbetrag von 45° gedreht werden. Eine derartige Drehung entspricht der Anschlußsituation verschiedener elektronischer Bauelemente, beispielsweise eines Transistors, wenn zwei benachbarte Lichtbalken abgebildet werden.

Die erfindungsgemäße Vorrichtung kann so geführt werden, daß das Lichtsymbol für die jeweilige Bestückungs- bzw. Bauelementposition ruhend oder, wie an sich bekannt, die Bestückungs- bzw. Bauelementposition umfahrend bewegt auf die Leiterplatte projiziert wird. Bei kleinen Bauteilen wird man im allgemeinen der ruhenden Anzeige den Vorzug geben, weil sie den Vorteil der geringeren visuellen Belastung der Arbeitsperson besitzt. Die erfindungsgemäße Vorrichtung bietet aber auch die Möglichkeit, durch Bewegung des Lichtsymbols die Position insbesondere größerer Bauelemente im dynamischen Betrieb zweifelsfrei zu bezeichnen. Auch dies führt zu einer visuellen Entlastung der Bedienungsperson, weil die variierend zur Anzeige gebrachten Lichtbalken wesentlich deutlichere Hinweise vermitteln als ein einzelner Lichtpunkt. Bei der dynamischen Betriebsart der erfindungsgemäßen Vorrichtung kann die gewünschte Bauteilposition durch den Lichtpunkt des Lichtsymbols kontinuierlich umzeichnet werden, wobei ggf. zusätzlich eine Drehung des Lichtsymbols und eine unterschiedliche variierende Abdeckung der Lichtbalken im Projektionsbild erfolgen können. Das Programm kann auch so gestaltet werden, daß der wandernde Lichtpunkt kurz an der Bestimmungsbohrung verharrt, wobei in dieser Projektionsphase der oder die den Bestückungszusammenhang erläuternden Lichtbalken erscheinen können. Die freie Programmierbarkeit aller aus Lichtbalken und Lichtpunkt zusammengesetzten Symbolkombinationen ermöglicht bei der erfindungsgemäßen Vorrichtung eine Anpassung an alle denkbaren Anwendungsfälle.

Im Interesse einer deutlichen Anzeige sind die Blendenöffnungen so ausgeführt, daß der Durchmesser der kreisrunden Öffnung größer ist als die Weite der untereinander abmessungsgleichen Schlitzöffnungen, deren Länge etwa das Zweifache des Durchmessers der kreisrunden Öffnung beträgt.

Für die Bewegung der Abdeckelemente relativ zu den in der Blende angeordneten Schlitzöffnungen stehen mehrere vorteilhafte Alternativen zur Verfügung. Bei einer ersten Ausführungsform sind die Abdeckelemente jeweils in Längsrichtung der Schlitzöffnungen durch einerseits daran und andererseits am Projektionsgehäuse befestigte Hubglieder bewegbar. Hierbei werden also die Schlitzöffnungen durch Verschiebung der Abdeckelemente in Richtung ihrer Längsachse verschlossen bzw. freigegeben. Bei einer zweiten Ausführungsform sind die Abdeckelemente jeweils in Querrichtung zu den Schlitzöffnungen durch einerseits daran und andererseits am Projektionsgehäuse befestigte Hubglieder bewegbar. Diese Ausführungsform bietet den Vorzug, daß die Stellwege, welche von den Abdeckelementen zurückgelegt werden müssen, besonders kurz sind. Bei einer dritten Ausführungsform schließlich ist die Anordnung so getroffen, daß die Abdeckelemente jeweils durch an die Blende angelenkte parallel zur Blendenebene bewegbare Schwenkglieder sind, an welche am Projektionsgehäuse angebrachte Hubglieder gelenkig angreifen. Es können aber auch klappenartige Abdeckelemente oder mehrere übereinander angeordnete zueinander und zur Blende um die Blendenmittelachse verdrehbare Abdeckscheiben zur Anwendung kommen.

Eine besonders funktionssichere und verzögerungsfreie Abdeckung von Einzelelementen des Lichtsymbols wird erreicht, wenn die Hubglieder jeweils aus einem Elektromagneten bestehen, dessen Hubstange an das Abdeckelement angreift, welches durch Aktivierung des Elektromagneten in die Abdeckstellung und bei stromlosem Elektromagneten durch eine Rückholfeder in die Öffnungsstellung bewegbar ist.

Zur Erzielung einer Drehung des Lichtsymbols kann die Vorrichtung so ausgestaltet sein, daß die Blende zusammen mit den Abdeckelementen und zugehörigen Hubgliedern um ihre senkrechte Mittelachse drehbar gelagert ist und mit am Projektionsgehäuse angebrachten Drehantriebsgliedern in Verbindung steht.

Die Drehantriebsglieder können zweckmäßig dadurch gebildet sein, daß an der Blende eine Außenverzahnung vorgesehen ist, die mit einem durch einen Schrittmotor antreibbaren ortsfest am Projektionsgehäuse gelagerten Zahnritzel kämmt. Diese Anordnung eignet sich besonders für ein kontinuierliches, d. h. stufenfreies Drehverstellen der Blende und der mit ihr verbundenen Elemente.

Wenn die Blende und die mit ihr verbundenen Elemente jedoch um einen festen Winkel von z. B. 45° verstellbar gelagert sein soll, ist es zweckmäßig, wenn an die Blende in der Nähe ihres Außenumfangs ein ortsfest am Projektionsgehäuse vorgesehenes Hubglied, vorzugsweise bestehend aus einem Elektromagneten und einer die Blende bei stromlosem Elektromagneten in die Ausgangsstellung zurückstellenden Rückholfeder angelenkt ist.

Die bevorzugte Ausführungsform der erfindungsgemäßen Vorrichtung ist dadurch gekennzeichnet, daß das Projektionsgehäuse die Form eines Hohlzylinders aufweist, etwa in der Mitte seiner Länge von einem Kardangelenkring konzentrisch umgeben ist und in der Nähe eines seiner Enden, vorzugsweise seines unteren Endes, mit zwei rechtwinklig zueinander ausgerichteten Führungsflächen fest verbunden ist, welchen jeweils das vordere Ende der rechtwinklig zur Führungsfläche ausgerichteten, ortsfest festgelegten und durch einen Schrittmotor antreibbaren Vorschubspindel anliegt, wobei an das Projektionsgehäuse eine die Führungsflächen und die Vorschubspindeln in Kontakt haltende Feder angreift, deren anderes Ende ortsfest gehalten ist, und deren Wirkungslinie die Winkelhalbierende des rechten Winkels zwischen den beiden Vorschubspindeln ist. Die so aufgebaute Vorrichtung gestattet unabhängige lineare Bewegungen des Projektionsgehäuses in der y-Achse oder in der x-Achse. Durch gleichzeitige Betätigung der beiden Vorschubspindeln sind aber auch überlagerte Bewegungen jeder Art möglich. Für jeden Auslenwinkel zwischen der Mittelachse des Projektionsgehäuses und der senkrechten Nullstellung dieser Achse und den vom Lichtsymbol auf der Leiterplatte zurückgelegten Weg besteht ein linearer für Bewegungen in der x- oder der y-Achse entkoppelbarer Zusammenhang.

Weitere Ausgestaltungen der Erfindung werden nachfolgend anhand der Ausführungsbeispiele der erfindungsgemäßen Vorrichtung darstellenden Zeichnungen näher erläutert. Darin zeigt:

Fig. 1, eine schematisierte perspektivische Gesamtansicht der Vorrichtung mit teilweise abgebrochen dargestellten Einzelheiten,

Fig. 2, einen Längsschnitt durch die Vorrichtung gemäß Fig. 1,

Fig. 3, eine Draufsicht auf die Blende,

Fig. 4, einen Querschnitt durch das Projektionsgehäuse entsprechend der Linie IV—IV in Fig. 2,

Fig. 5, einen der Fig. 4 ähnlichen Querschnitt, jedoch mit einer anderen Betätigungsanordnung für die Abdeckelemente,

Fig. 6, einen weiteren der Fig. 4 ähnlichen Querschnitt mit einer weiteren Ausführungsform der Betätigungsanordnung für die Abdeckelemente,

Fig. 7, einen Querschnitt durch das Projektionsgehäuse mit eingezeichneten Drehantriebsgliedern,

Fig. 8, einen der Fig. 7 ähnlichen Querschnitt mit einer anderen Ausführungsform der Drehantriebsglieder,

Fig. 9, die Draufsicht auf einen Platinenausschnitt mit eingezeichnetem Auflichtsymbol,

Fig. 10, einen weiteren Platinenausschnitt mit eingezeichnetem Auflichtsymbol und

Fig. 11, zwei weitere Variationsmöglichkeiten für das Auflichtsymbol.

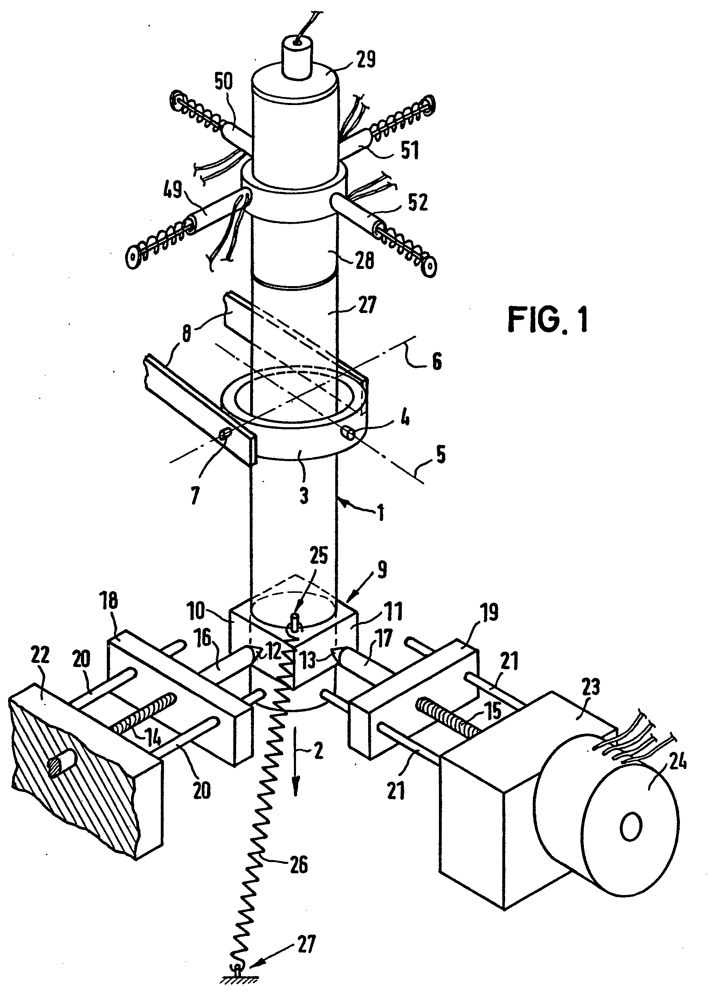

Zur Erläuterung der Gesamtanordnung wird zunächst auf Fig. 1 Bezug genommen. Das darin dargestellte allgemein mit der Bezugszahl 1 bezeichnete langgestreckte Projektionsgehäuse 1 besitzt die Form eines Hohlzylinders, der nach unten hin in Richtung des den Lichtausfall markierenden Pfeiles 2 geöffnet ist. Zur kardanischen Aufhängung des Projektionsgehäuses 1 ist dieses von dem Kardangelenkring 3 konzentrisch umgeben, der über zwei diametral gegenüberliegende Gelenkzapfen 4 schwenkbar mit dem Projektionsgehäuse 1 verbunden ist. Rechtwinklig zu der durch die Gelenkzapfen 4 markierten Schwenkachse 5 verläuft eine weitere Schwenkachse 6, die von zwei diametral gegenüberliegenden Gelenkzapfen 7 gebildet wird. Die Gelenkzapfen 7 verbinden den Kardangelenkring 3 schwenkbar mit ortsfest angebrachten Aufhängearmen 8.

Am unteren Ende des Projektionsgehäuses 1 ist dieses von einem zentrisch durchbohrten in der Draufsicht die Form eines Quadrates aufweisenden mit der allgemeinen Bezugszahl 9 bezeichneten Profilklotz umgeben, der am Projektionsgehäuse 1 befestigt ist. Der Profilklotz 9 weist die beiden rechtwinklig zueinander ausgerichteten Führungsflächen 10 und 11 auf, denen die Spitzen 12 und 13 der zugehörigen Vorschubspindeln 14 bzw. 15 anliegen. Die Spitzen 12 und 13 sind jeweils am Ende hülsenförmiger Gewindemuttern 16 bzw. 17 angebracht, die fest in Parallelführungsplatten 18 bzw. 19 eingelassen sind. Die Parallelführungsplatten 18 und 19 sind an jeweils zwei Führungsstangen 20 bzw. 21 verschiebbar geführt, die ihrerseits starr an Antriebsblöcken 22 bzw. 23 befestigt sind. Die Vorschubspindeln 14 und 15 sind jeweils mit Feingewinde ausgestattet und in die Gewindemuttern 16 und 17 eingeschraubt. Den Antrieb der Vorschubspindeln in beiden Drehrichtungen bewirkt jeweils ein mit dem Antriebsblock 22 bzw. 23 fest verbundener Schrittmotor, von denen in der Zeichnung nur der zum Antriebsblock 23 gehörende Schrittmotor 24 dargestellt ist.

Angenommen, die Vorschubspindel 15 würde durch den Schrittmotor 24 in einer der beiden Drehrichtungen angetrieben, so bewirkt die der Führungsfläche 11 anliegende Spitze 13 ein Verschwenken des Projektionsgehäuses 1 um die Schwenkachse 6, während die Führungsfläche 10 auf der Spitze 12 der anderen angetriebenen Vorschubspindel 14 gleitet. Bei Antrieb der Vorschubspindel 14 und gleichzeitigem Stillstand der Vorschubspindel 15 sind die Verhältnisse analog. Hierbei verschwenkt das Projektionsgehäuse 1 mit allen daran befestigten Teilen um die Schwenkachse 5. Die kardanische Aufhängung ermöglicht jedoch auch überlagerte Bewegungen, wobei beide Vorschubspindeln 14 und 15 gleichzeitig und ggf. auch in unterschiedlichen Drehrichtungen angetrieben werden, was zu einem Verschwenken des Projektionsgehäuses sowohl um die Achse 5 als auch um die Achse 6 führt.

An den Profilklotz 9 greift bei 25 das Ende einer Zugfeder 26 an, deren anderes Ende bei 27 festgelegt ist. Die Wirkungslinie der Feder 26 verläuft auf der Winkelhalbierenden zwischen den Achsen der beiden Vorschubspindeln 14 und 15. Die Feder 26 sorgt dafür, daß die Führungsflächen 10 und 11 stets den jeweils zugehörigen Spitzen 12 bzw. 13 anliegen.

Wie aus Fig. 1 hervorgeht, kann das Projektionsgehäuse 1 aus einem Unterteil 27 und einem Oberteil 28 bestehen, wobei das Oberteil 28 um die Mittelachse des Gehäuses gegenüber dem unverdrehbar angeordneten Unterteil 27 aus den noch zu erläuternden Gründen drehbar ist.

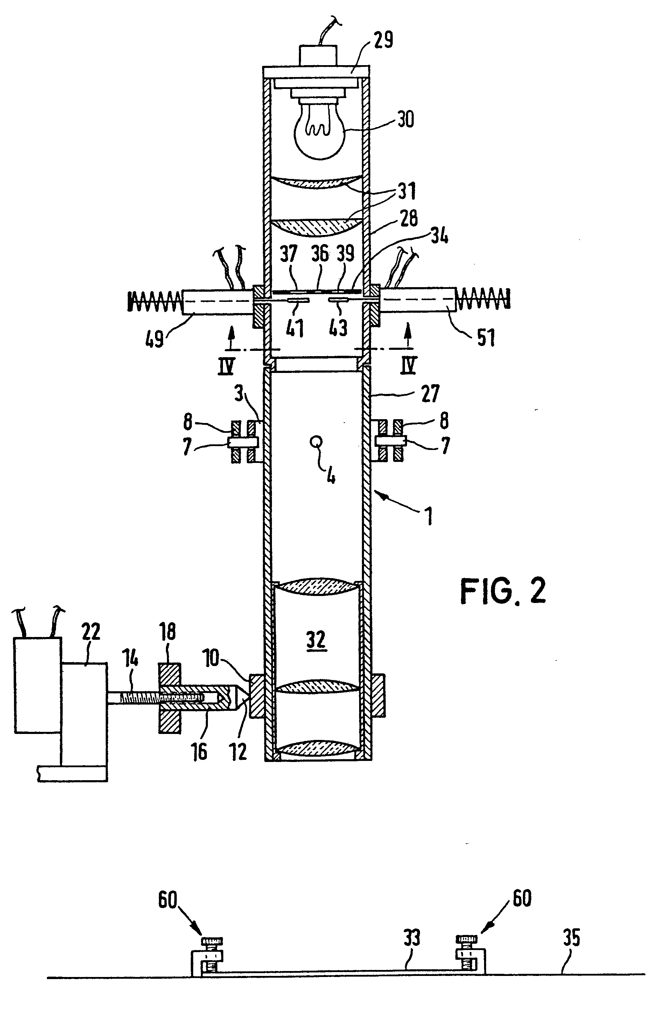

Zur näheren Erläuterung der im Inneren des Projektionsgehäuses 1 angebrachten Bauteile wird nunmehr auf Fig. 2 Bezug genommen. Wie daraus hervorgeht, wird das obere Ende des Projektionsgehäuses 1 durch einen Deckel 29 verschlossen, welcher zugleich mit einer Fassung für eine die Projektionslichtquelle darstellende Glühlampe 30 versehen ist. Unterhalb der Glühlampe 30 befindet sich ein Kondensorlinsensystem 31. Am unteren Ende des Gehäuses 1 ist das aus mehreren Linsengliedern bestehende Projektionsobjektiv 32 angebracht, das zum Zwecke des Fokussierens innerhalb des Gehäuses 1 axial verschiebbar angebracht sein kann, damit auf der durch die Oberfläche der Leiterplatte 33 gebildeten Bildebene ein scharfes Abbild der zwischen dem Kondensorlinsensystem 31 und dem Projektionsobjektiv 32 im Gehäuse 1 befindlichen Blende 34 erzeugt werden kann. Die Leiterplatte 33 ist in definierter Lage durch Klemmelemente 60 auf dem Bestückungstisch 35 festgespannt.

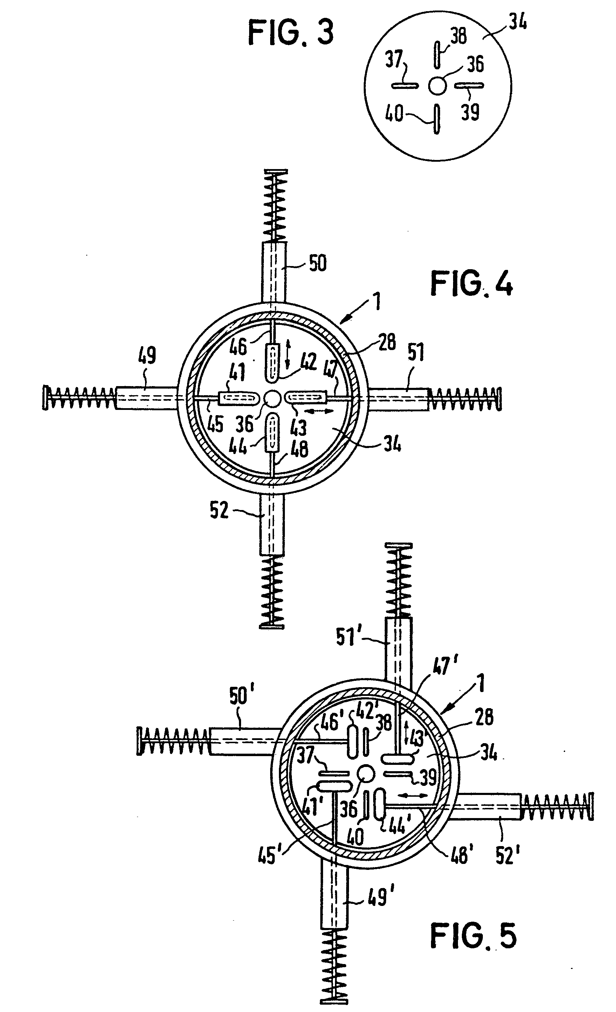

Die Blende 34 besteht aus einer in definierter Lage im Gehäuse 1 angebrachten Platte, die rechtwinklig zur Mittelachse des Gehäuses 1 angeordnet ist, in ihrer Mitte die kreisförmige Öffnung 36 und die sie kreuzförmig umgebenden Schlitzöffnungen 37 bis 40 aufweist. Wie Fig. 3 verdeutlicht, is die Weite der Schlitzöffnungen 37 bis 40 geringer als der Durchmesser der kreisrunden Öffnung 36. In den Figuren sind die Abmessungen der kreisförmigen Öffnung und der Schlitzöffnungen aus Gründen der Deutlichkeit in Relation zu den übrigen gezeichneten Bauteilen wesentlich größer als in Wirklichkeit dargestellt.

Wie aus den Fig. 4 und 5 hervorgeht, ist jeder Schlitzöffnung 37 bis 40 ein Abdeckelement 41 bis 44 zugeordnet. Die Abdeckelemente sind jeweils an den Hubstangen 45 bis 48 der Elektromagnete 49 bis 52 befestigt. Die Elektromagnete 49 bis 52 sind ihrerseits am Projektionsgehäuse 1 fest angebracht. In Fig. 4 sind die Abdeckelemente 41 bis 44 relativ zu den Schlitzöffnungen 37 bis 40 so an den Hubstangen 45 bis 48 befestigt, daß die Schlitzöffnungen in ihrer Längsrichtung von den Abdeckelementen schieberartig abgedeckt bzw. freigegeben werden. Dagegen ist die Anordnung bei der Ausführungsform gemäß Fig. 5 so getroffen, daß die bezüglich ihrer Längsachse quer an den Hubstangen 45 bis 48 befestigten Abdeckelemente 41' bis 44' in Querrichtung zu den Schlitzöffnungen 37 bis 40 bewegt werden.

In Fig. 4 ist die Anordnung in einer Stellung gezeigt, bei welcher sämtliche Schlitzöffnungen 37 bis 40 der Blende 34 durch die zugehörigen Abdeckelemente 41 bis 44 abgedeckt sind, so daß auf die Leiterplatte 33 lediglich infolge der freien kreisrunden Öffnung 36 ein Lichtpunkt erzeugt wird. In Fig. 5 dagegen ist die Lage der Teile derart, daß alle Blendenöffnungen freigelegt sind, wodurch die Glühbirne 30 mit Hilfe des Kondensorlinsensystems 31 under des Projektionsobjektivs 32 auf der Leiterplatte 33 ein vollständiges Lichtsymbol entwirft. Selbstverständlich können die Elektromagnete 49 bis 52 einzeln oder in Gruppen angesteuert werden, so daß im Rahmen des Gesamtlichtsymbols jede denkbare Konfiguration erzielt werden kann.

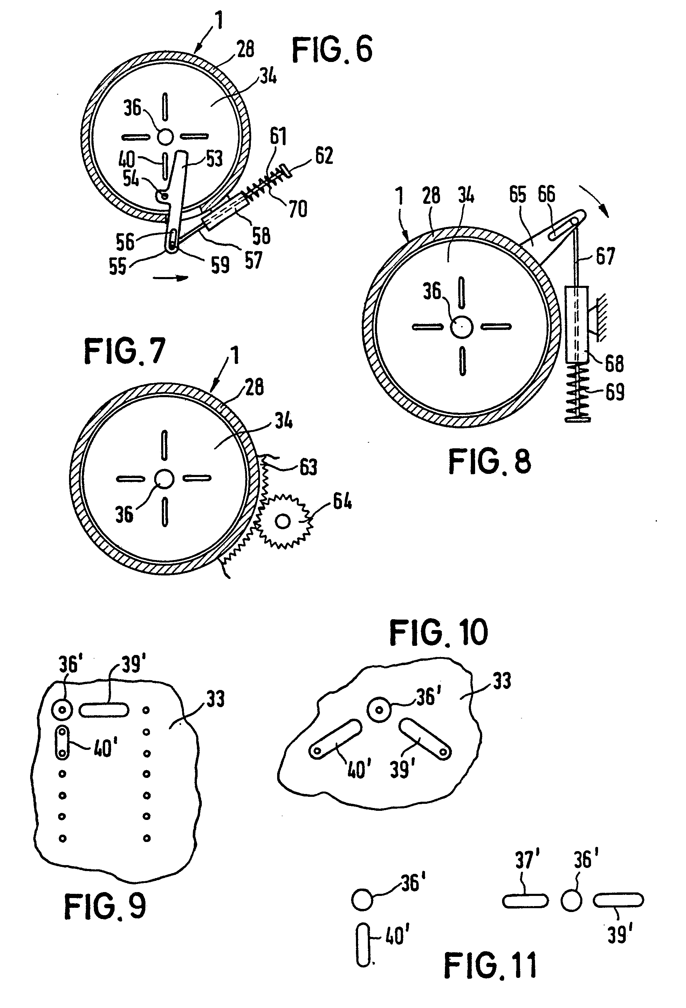

Die Abdeckung der Öffnungen in der Blende 34 ist nicht auf die beiden mit Bezug auf die Fig. 4 und 5 beschriebenen Ausführungsbeispiele beschränkt. In Fig. 6 ist ein weiteres Ausführungsbeispiel dargestellt, bei welchem der Schlitzöffnung 40 das schwenkbare Abdeckelement 53 zugeordnet ist, das um einen an der Blende 34 befindlichen Schwenkzapfen 54 parallel zur Blendenebene bewegbar ist. Für den Antrieb des Abdeckelements 53 ist dieses mit einer Verlängerung 55 versehen, in deren Langloch 56 ein an der Hubstange 57 des Elektromagneten 58 befestigter Stift 59 eingreift. Der Elektromagnet 58 ist auch in diesem Fall ortsfest am Projektionsgehäuse 1 befestigt. Die mit Bezug auf die Schlitzöffnung 40 beschriebene und in Fig. 6 gezeichnete Abdeckanordnung ist selbstverständlich in entsprechender Form auch für die drei übrigen Schlitzöffnungen vorgesehen.

Wie aus den Ziechnungen hervorgeht und zur Vereinfachung lediglich mit Bezug auf die Fig. 6 beschrieben werden soll, ist der Elektromagnet 58 mit einer als Schraubendruckfeder ausgebildeten Rückholfeder 70 ausgerüstet, welche eine Verlängerung 61 der Hubstange 57 umgibt und sich einerseits am Elektromagneten 58 und andererseits an einer an der Verlängerung 61 befestigten Scheibe 62 abstützt. Die Rückholfeder 70 sorgt dafür, daß das an die Hubstange angeschlossene Abdeckelement bei stromlosem Elektromagneten die zugeordnete Schlitzöffnung freigibt. Entsprechend sind selbstverständlich die in den übrigen Figuren dargestellten Elektromagneten ausgerüstet.

Die drehbare Lagerung der Blende 34 aum ihre senkrechte Mittelachse kann dadurch realisiert werden, daß am Oberteil 28 des Projektionsgehäuses 1 eine Außenverzahnung 63 befestigt ist, die mit dem ortsfest und drehbar gelagerten durch einen Schrittmotor (nicht dargestellt) angetriebenen Zahnritzel 64 kämmt (Fig. 7). Bei Drehantrieb des Oberteils 28 des Gehäuses 1 nehmen alle am Oberteil 28 angebrachten Bauelemente, nämlich die Abdeckelemente mit den zugehörigen Hubgliedern und auch die Lichtquelle 30 und das Kondensorlisensystem 31, an der Drehung teil, was wegen der Rotationssymmetrie der Anordnung bezüglich der Lage der Glühbirne 30 und des Kondensorsystems 31 unschädlich ist. In Fig. 7 wurden zur Vereinfachung die Abdeckelemente und die ihnen zugeordneten Hubglieder nicht mit eingezeichnet.

Die Drehung des Oberteils 28 und damit der Blende 34 kann aber auch auf die in Fig. 8 angegebene Weise bewerkstelligt werden. Hierbei ist am Oberteil 28 ein Hebelarm 65 befestigt, in dessen Langloch 66 die Hubstange 67 eines ortsfest angeordneten Elektromagneten 68 eingreift. Auch dieser Elektromagnet ist, wie schon zuvor beschrieben, mit einer Rückholfeder 69 ausgerüstet. Die in Fig. 8 gezeigte Anordnung eignet sich besonders für solche Fälle, in denen die Blende 34 um einen festen Winkel von z. B. 45° verstellt werden soll. Die Anordnung könnte selbstverständlich auch so getroffen sein, daß der Hebel 65 direkt an den Außenumfang der Blende 34 angreift.

In Fig. 9 ist die Projektion der Auflichtanzeige auf den ersten Anschluß einer integrierten Schaltung dargestellt, welche sich auf der Leiterplatte 33 befindet. Zu diesem Zweck weist der von der kreisförmigen Öffnung 36 der Blende 34 entworfene Lichtpunkt 36′ auf die erste Anschlußbohrung der in der linken Bildhälfte dargestellten Bohrungsreihe. Zur Kennzeichnung der weiterhin vorzunehmenden Anschlußschritte sind die Schlitzöffnungen 37 und 38 der Blende 34 abgedeckt, so daß die offenen Schlitzöffnungen 40 und 39 Lichtbalken 40′ und 39′ auf der Leiterplatte 33 abbilden. In Fig. 10 ist ein Lichtsymbol auf die Leiterplatte 33 projiziert, dessen Lichtpunkt 36 auf die mittlere Bohrung des Basisanschlusses eines Transistors weist, während die um 45° nach rechts gedrehten Lichtbalken 40′ und 39′ die beiden äußeren Bohrungen der Transistorbasis erfassen.

Von der Vielzahl der möglichen Lichtsymbole sind in der linken Hälfte der Fig. 11 ein Lichtpunkt 36′ und ein nach unten weisender Lichtbalken 40′ dargestellt, während die rechte Hälfte der Fig. 11 ein aus dem Lichtpunkt 36 und den Lichtbalken 37′ und 39′ gebildetes Lichtsymbol veranschaulicht.

Wie in Fig. 2 angegeben ist, befinden sich die Abdeckelemente unterhalb der Blende 34. Die Anordnung kann aber auch so getroffen werden, daß sich die Abdeckelemente oberhalb der Blende 34 befinden, d. h. der Glühbirne 30 zugekehrt sind.

Bei der in Fig. 7 gezeigten Anordnung kann die Außenverzahnung auch direkt an der Blende 34 angebracht sein, wobei das Ritzel durch die Wandung des Gehäuses 1 hindurchgreift. Bei Verwendung eines Miniaturschrittmotors können das Ritzel und der Motor auch an der Innenwand des Gehäuses befestigt sein. In diesem Fall sind auch die Abdeckelemente und ihre Antriebselemente an der Blende befestigt.

**Patentansprüche**

1. Vorrichtung zur Erzeugung einer durch ein festgelegtes Bestückungsprogramm gesteuerten Auflichtanzeige auf einer mit elektronischen Bauelementen zu bestückenden Leiterplatte, auf welcher ein Lichtpunkt den Ort und die Sequenz der vorzunehmenden Bestückungsschritte anzeigt, mit einer zwischen einer Lichtquelle (30) und einem Projektionsobjektiv (32) angeordneten Blende (34), dadurch gekennzeichnet, daß die Blende (34) in einem kardanisch aufgehängten (Achsen 5 und 6) und durch zwei im rechten Winkel zueinander und parallel zum Bestückungstisch (35) bzw. darauf befindlichen Leiterplatte (33) ausgerichtete unabhängig voneinander antreibbare Vorschubspindeln (14, 15) bewegbaren Projektionsgehäuse (1) angeordnet ist und in ihrer Mitte eine kreisrunde Öffnung (36) und vier um die kreisrunde Öffnung nach Art eines Kreuzes angeordnete jeweils um 90° gegeneinander versetzte Schlitzöffnungen (37 bis 40) besitzt, wobei jeder Schlitzöffnung ein unabhängig bewegbares Abdeckelement (41 bis 44) zugeordnet ist.

2. Vorrichtung nach Anspruch 1, dadurch gekennzeichnet, daß der Durchmesser der kreisrunden Öffnung (36) größer ist als die Weite der untereinander abmessungsgleichen Schlitzöffnungen (37 bis 40), deren Länge etwa das Zweifache des Durchmessers der kreisrunden Öffnung beträgt.

3. Vorrichtung nach Anspruch 1 oder 2, dadurch gekennzeichnet, daß die Abdeckelemente (41 bis 44) jeweils in Längsrichtung der Schlitzöffnungen (37 bis 40) durch einerseits daran und andererseits am Projektionsgehäuse (1) befestigte Hubglieder (49 bis 52) bewegbar sind.

4. Vorrichtung nach Anspruch 1 oder 2, dadurch gekennzeichnet, daß die Abdeckelemente (41′ bis 44′) jeweils in Querrichtung zu den Schlitzöffnungen (37 bis 40) durch einerseits daran und andererseits am Projektionsgehäuse (1) befestigte Hubglieder (49 bis 52) bewegbar sind.

5. Vorrichtung nach Anspruch 1 oder 2, dadurch gekennzeichnet, daß die Abdeckelemente (41' bis 44') jeweils durch an die Blende (34) angelenkte (54) parallel zur Blendenebene bewegbare Schwenkglieder (53) sind, an welche am Projektionsgehäuse (1) angebrachte Hubglieder (58) gelenkig angreifen.

6. Vorrichtung nach einem der Ansprüche 3 bis 5, dadurch gekennzeichnet, daß die Hugblieder (58) jeweils aus einem Elektromagneten bestehen, dessen Hubstange (57) an das Abdeckelement (53) angreift, welches durch Aktivierung des Elektromagneten in die Abdeckstellung und bei stromlosem Elektromagneten durch eine Rückholfeder (70) in die Öffnungsstellung bewegbar ist.

7. Vorrichtung nach einem der Ansprüche 1 bis 6, dadurch gekennnzeichnet, daß die Blende (34) zusammen mit den Abdeckelementen und zugehörigen Hubgliedern um ihre senkrechte Mittelachse drehbar gelagert ist und mit am Projektionsgehäuse (1) angebrachten Drehantriebsgliedern in Verbindung steht.

8. Vorrichtung nach Ansprüch 7, dadurch gekennzeichnet, daß an der Blende (34) eine Außenverzahnung (63) vorgesehen ist, die mit einem durch einen Schrittmotor antreibbaren ortsfest am Projektionsgehäuse (1) gelagerten Zahnritzel (64) kämmt.

9. Vorrichtung nach Ansprüch 7, dadurch gekennzeichnet, daß an die Blende (34) in der Nähe ihres Außenumfangs ein ortsfest am Projektionsgehäuse (1) vorgesehenes Hubglied (68), vorzugsweise bestehend aus einem Elektromagneten und einer die Blende bei stromlosem Elektromagneten in die Ausgangsstellung zurückstellenden Rückholfeder (70) angelenkt ist.

10. Vorrichtung nach einem der Ansprüche 1 bis 9, dadurch gekennzeichnet, daß das Projektionsgehäuse (1) die Form eines Hohlzylinders aufweist, etwa in der Mitte seiner Länge von einem Kardangelenkring (3) konzentrisch umgeben ist und in der Nähe eines seiner Enden, vorzugsweise seines unteren Endes, mit zwei rechtwinklig zueinander ausgerichteten Führungsflächen (10, 11) fest verbunden ist, welchen jeweils das vordere Ende (12, 13) der rechtwinklig zur Führungsfläche ausgerichteten, ortsfest gelagerten und durch einen Schrittmotor (24) antreibbaren Vorschubspindel (14 bzw. 15) anliegt, wobei an das Projektionsgehäuse (1) eine die Führungsflächen (10, 11) und die Vorschubspindeln (14, 15) in Kontakt haltende Feder (26) angreift, deren anderes Ende ortsfest gehalten ist, und deren Wirkungslinie die Winkelhalbierende des rechten Winkels zwischen den beiden Vorschubspindeln (14, 15) ist.

## Claims

1. A device for producing, controlled by a fixed mounting programme, an incident-light display on a circuit board on which electronic components are to be mounted, a light spot indicating on the circuit board the location and the sequence of the mounting steps to be undertaken, the device having a diaphragm (34) disposed between a light source (30) and a projection lens (32), characterised in that the diaphragm (34) is disposed in a gimbal-mounted (axes 5 and 6) projector housing (1) adapted for movement by two independently driveable feed spindles (14, 15) which are aligned at right-angles to each other and parallel with the mounting table (35) or the circuit board (33) located thereon, and has in its centre a circular aperture (36) and, disposed around the circular aperture in a cruciform pattern and at an angle of 90° in respect of one another, four slit apertures (37 to 40) and in that an independently movable masking element (41 to 44) is associated with each slit aperture.

2. A device according to Claim 1, characterised in that the diameter of the circular aperture (36) is greater than the width of the slit apertures (37 to 40) which are all of identical dimensions and the length of which amounts to approximately twice the diameter of the circular aperture.

3. A device according to Claim 1 or 2, characterised in that the masking elements (41 to 44) are adapted for movement in each case in the longitudinal direction of the slit apertures (37 to 40) by reciprocatingly movable members (49 to 52) fixed at one end on the masking elements and at the other on the projector housing (1).

4. A device according to Claim 1 or 2, characterised in that the masking elements (41' to 44') can in each case be moved in a transverse direction in relation to the slit apertures (37 to 40) by reciprocatingly movable elements (49 to 52) fixed at one end on the masking elements and at the other on the projector housing (1).

5. A device according to Claim 1 or 2, characterised in that the masking elements (41' to 44') are in each case pivotable members (53) adapted for movement parallel with the diaphragm plane and articulated at (54) on the diaphragm (34), reciprocatingly movable members (58) mounted on the projector housing (1) articulatingly engaging the pivotable members (53).

6. A device according to one of Claims 3 to 5, characterised in that the reciprocatingly movable elements (58) consist in each case of an electromagnet, the reciprocatingly movable bar (57) of which engages the masking element (53) so that the latter can be moved into the masking position by the electromagnet being energised and into the open position by a return spring (70) when the electromagnet has no current passing through it.

7. A device according to one of Claims 1 to 6, characterised in that, together with the masking elements and associated reciprocatingly movable elements, the diaphragm (34) is mounted to be rotatable about its vertical central axis and is connected to rotating drive members mounted on the projector housing (1).

8. A device according to Claim 7, charaterised in that provided on the diaphragm (34) is a system of externally cut teeth (63) meshing with a pinion (64) mounted rigidly on the projector housing (1) and adapted to be driven by a stepping motor.

9. A device according to Claim 7, characterised in that articulated on the diaphragm (34) in the vicinity of its outer periphery is a reciprocatingly movable element (68) provided rigidly on the projector housing (1) and consisting preferably of an electromagnet and a return spring (70) which restores the diaphragm to the starting position when no current is passing through the electromagnet.

10. A device according to one of Claims 1 to 9, characterised in that the projector housing (1) takes the form of a hollow cylinder and, substantially in the middle of its length is concentrically encircled by a gimbal mounting ring (3) and, in the vicinity of one of its ends, preferably its lower end, is rigidly connected to two guide faces (10, 11) which are orientated at a right-angle to each other, and on which bear in each case the respective front ends (12, 13) of the feed spindles (14, 15) which are rigidly mounted at a right-angle to the guide face and adapted to be driven by a stepping motor (24), and in that a spring (26) maintains the guide faces (10, 11) and the feed spindles (14, 15) in contact, the other end of the spring being rigidly held, the line of action of the spring being the bisector of the right-angle between the two feed spindles (14, 15).

**Revendications**

1. Dispositif pour la projection d'une indication lumineuse, commandée par un programme d'équipement déterminé, sur une carte imprimée à équiper avec des composants électroniques et sur laquelle un point lumineux indique l'emplacement et la séquence des pas d'équipement à effectuer, avec un diaphragme (34) disposé entre une source lumineuse (30) et un objectif de projection (32), ledit dispositif étant caractérisé en ce que le diaphragme (34) est logé dans un boîtier de projection (1) à cardan (axes 5 et 6), est mobile à l'aide de deux vis d'avance (14, 15) perpendiculaires, entraînées chacune parallèlement à la table d'équipement (35) et à la carte imprimée placée sur cette dernière, et comporte en son centre une ouverture circulaire (36) entourée par quatre fentes (37 à 40) en croix, décalées de 90° et munies chacune d'une cache (41 à 44) mobile individuellement.

2. Dispositif selon revendication 1, caractérisé en ce que le diamètre de l'ouverture circulaire (36) est supérieur à la largeur des fentes (37 à 40) identiques, dont la longueur est sensiblement égale au double du diamètre de l'ouverture circulaire.

3. Dispositif selon une des revendications 1 et 2, caractérisé en ce que chaque cache (41 à 44) est mobile suivant le grand axe des fentes (37 à 40) par un organe de translation (49 à 52) fixé d'une part sur le cache et d'autre part sur le boîtier de projection (1).

4. Dispositif selon une des revendications 1 et 2, caractérisé en ce que chaque cache (41' à 44') est mobile transversalement par rapport aux fentes (37 à 40), par un organe de translation (49 à 52) fixé d'une part sur le cache et d'autre part sur le boîtier de projection (1).

5. Dispositif selon une des revendications 1 et 2, caractérisé en ce que chaque cache (41' à 44') est mobile par un organe de pivotement (53), articulé sur le diaphragme (34), se déplaçant parallèlement au plan du diaphragme et sur lequel est articulé un organe de translation (58) fixé sur le boîtier de projection (1).

6. Dispositif selon une quelconque des revendications 3 à 5, caractérisé en ce que chaque organe de translation (58) est constitué par un électroaimant dont la tige (57) agit sur le cache (53) que l'électroaimant alimenté amène en position de masquage et qu'un ressort de rappel (70) ramène dans la position d'ouverture quand l'électroaimant n'est pas alimenté.

7. Dispositif selon une quelconque des revendications 1 à 6, caractérisé en ce que le diaphragme (34) est, avec les caches et les organes de translation correspondants, monté en rotation autour de son axe vertical et relié à des organes de rotation fixés sur le boîtier de projection (1).

8. Dispositif selon revendication 7, caractérisé en ce que le diaphragme (34) comporte une denture extérieure (63), qui engrène un pignon (64) solidaire du boîtier de projection (1) et entraîné par un moteur pas à pas.

9. Dispositif selon revendication 7, caractérisé en ce que le diaphragme (34) est articulé au voisinage de son pourtour sur un organe de translation (68) solidaire du boîtier de projection (1) et constitué de préférence par un électroaimant et un ressort de rappel (70) ramenant le diaphragme dans la position de base quand l'électroaimant n'est pas alimenté.

10. Dispositif selon une quelconque des revendications 1 à 9, caractérisé en ce que le boîtier de projection (1) présente la forme d'un cylindre creux, est entouré concentriquement par un croisillon annulaire (3), sensiblement au milieu de sa longueur, et est solidaire de deux faces de guidage (10, 11) voisines d'une de ses extrémitiés, de l'extrémeté inférieure de préférence, et dont chacune prend appui par son extrémité antérieure (12, 13) sur une vis d'avance (14, 15) perpendiculaire à la face de guidage, fixe et entraînée par un moteur pas à pas (24), le contact entre les faces de guidage (10, 11) et les vis d'avance (14, 15) étant établi par un ressort (26), dont une extrémité est accrochée sur le boîtier de projection (1), la seconde extrémité est fixe et la ligne d'action est la bissectrice de l'angle droit formé par les deux vis d'avance (14, 15).

FIG. 1

FIG. 2

FIG. 3

FIG. 4

FIG. 5

FIG. 6

FIG. 7

FIG. 8

FIG. 10

FIG. 9

FIG. 11